# EUROPEAN PATENT SPECIFICATION

(11) **EP 0 383 095 B1**
(45) Date of publication and mention of the grant of the patent: **21.06.1995**
(21) Application number: 90101884.6
(22) Date of filing: 31.01.1990
(51) Int. Cl.: G05F 3/24, G05F 3/30

(54) **BiCMOS reference network**
BICMOS-Referenznetzwerk
Réseau de référence bicmos

(30) Priority: 14.02.1989 US 310800
(43) Date of publication of application: 22.08.1990
(73) Proprietor: TEXAS INSTRUMENTS INCORPORATED, Dallas Texas 75265 (US)
(72) Inventor: Tran, Hiep V., Carrolton, Texas 75007 (US)
(74) Representative: Leiser, Gottfried, Dipl.-Ing.

(56) References cited:
- EP-A- 0 282 725
- GB-A- 2 067 015
- US-A- 4 539 491
- US-A- 4 588 941
- PATENT ABSTRACTS OF JAPAN, vol. 12, no. 268 (E-638)[3115], 27th July 1988;& JP-A-6350114 (TOSHIBA CORP.) 03-03-1988

## Description

This invention is in the field of BiCMOS integrated circuits. It relates to a reference network comprising the features of the precharacterizing part of claim 1. A reference network of this type is disclosed in EP-A-0 282 725.

### BACKGROUND OF THE INVENTION

Until now, the signal voltage swing and signal margin of emitter coupled logic, ECL, has been controlled by a single on-chip voltage reference circuit. The disadvantage of this conventional approach is that voltages are only accurately referenced to power supply levels physically near the reference circuits. The voltage drops associated with power supply currents cause the actual power supply levels to vary considerably across the semiconductor chip and invalidate the reference voltages. This has been found to be particularly true when ECL logic is used in the design of VLSI BiCMOS circuits.

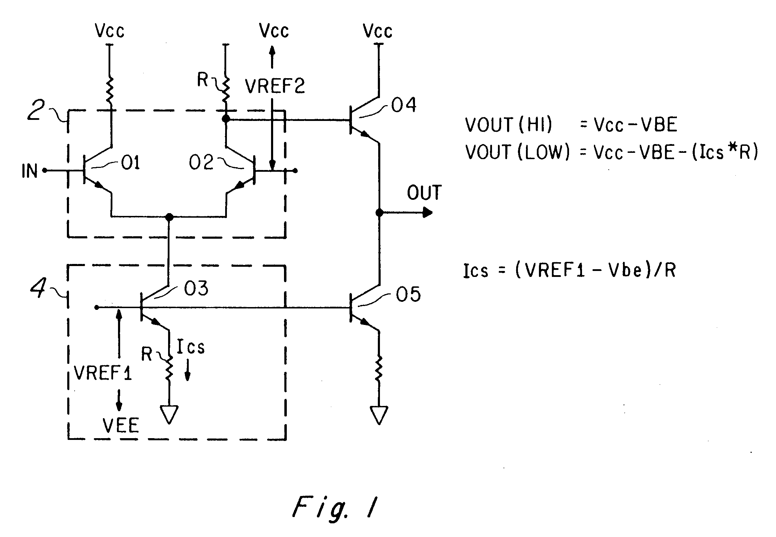

Figure 1 illustrates a standard ECL gate. It comprises differential pair 2 (which includes N-type bipolar transistors O1 and O2) and source follower stage 4. N-type bipolar transistors O4 and O5 are connected together so as to form the output of the gate. The gate's power dissipation is controlled by the VREF1 signal (VREF1 being a voltage). If transistor O3 is kept out of saturation during its operation, then current Ics (through resistor R connected to the emitter of transistor O3) is equal to (VREF1-VBE)/R. The VREF1 voltage controls the output voltage swing of the gate. It can be seen that the difference between the high and the low output levels of this gate is Ics*R and that this is a voltage drop across the pull-up resistor of the differential pair. The input trip point of this gate is set up by a VREF2 signal voltage between power supply voltage VCC and the voltage at the base of transistor O2. If the input of this ECL gate (node IN) is driven by the signal from the output of another ECL gate similar to this gate, then VREF2 has to be set at the midpoint of this output voltage swing to achieve maximum signal margin and performance. If VREF1 and VREF2 are kept at constant levels, then voltage drops on the VCC and VEE power lines will invalidate both voltage references.

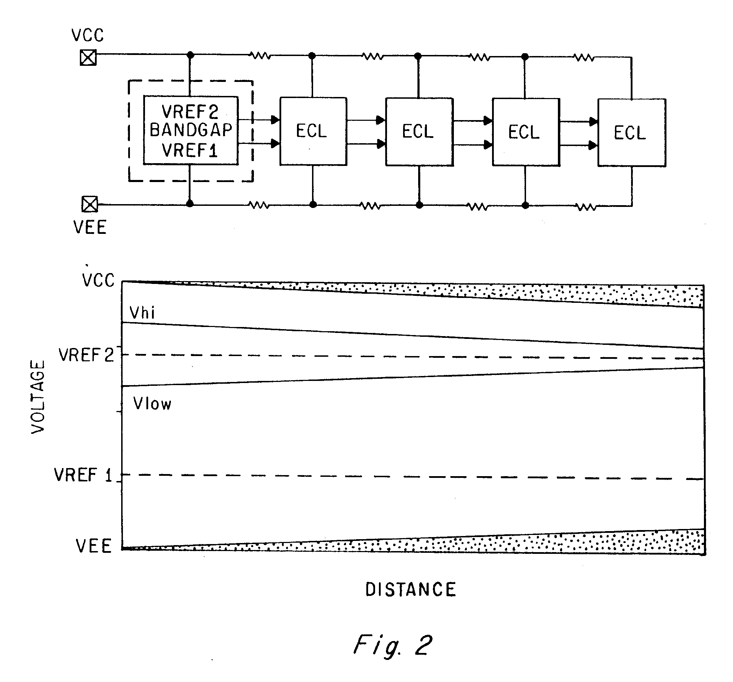

Figure 2 illustrates the physical layout of VCC and VEE power supply pads on a chip and an associated graph. In this figure, the pads are near each other. The band-gap reference circuit which produces voltages VREF1 and VREF2 is placed near the power pads and blocks of ECL circuits are placed at increasing distances away from the power pads. Resistances in the power lines are shown modeled as resistors R.

The graph in figure 2 illustrates selected voltages vs. distance. The X axis gives the distance from the power pads of the corresponding ECL circuit shown above it and the Y axis shows the voltage of major signals in the ECL gates. The voltage drops along the VCC and VEE power lines are shown here in the graph as the dark regions. The ECL circuit at the end of the power lines suffers the most voltage drop. Because VREF1 and VREF2 are referenced to the power pads, they are at a constant level regardless of how far they are away from the pads. However, the current reproduced by VREF1 at the local ECL circuit is not constant. This will effect the low output voltage of ECL gates along the power lines. The high output of the ECL gate is also lowered by voltage drops in the VCC line. These effects severely degrade the signal margin. If the voltage drops in the power line are greater than one half of output voltage swing, this will probably result in complete chip operation failure.

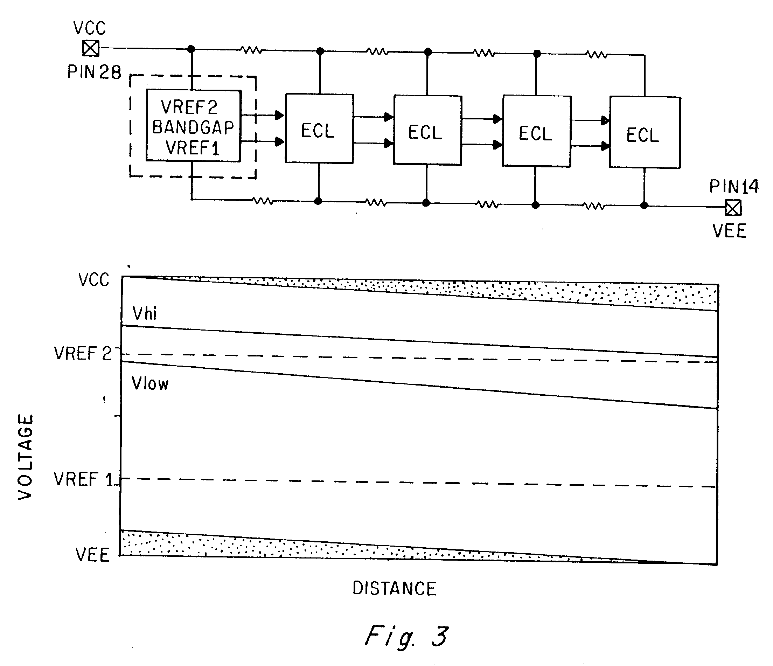

Figure 3 illustrates an example of a SRAM which is designed to fit in a standard JDEC package. Figure 3 also illustrates a corresponding graph of selected voltages vs. distance, a similar type of plot to that illustrated in figure 2. It has the power pads at opposite ends of the chip. The effects of the power line voltage drops are almost the same except that now the signal voltage swings are larger and may cause catastrophic failure due to the forward biasing of the next ECL stages which are receiving output signals.

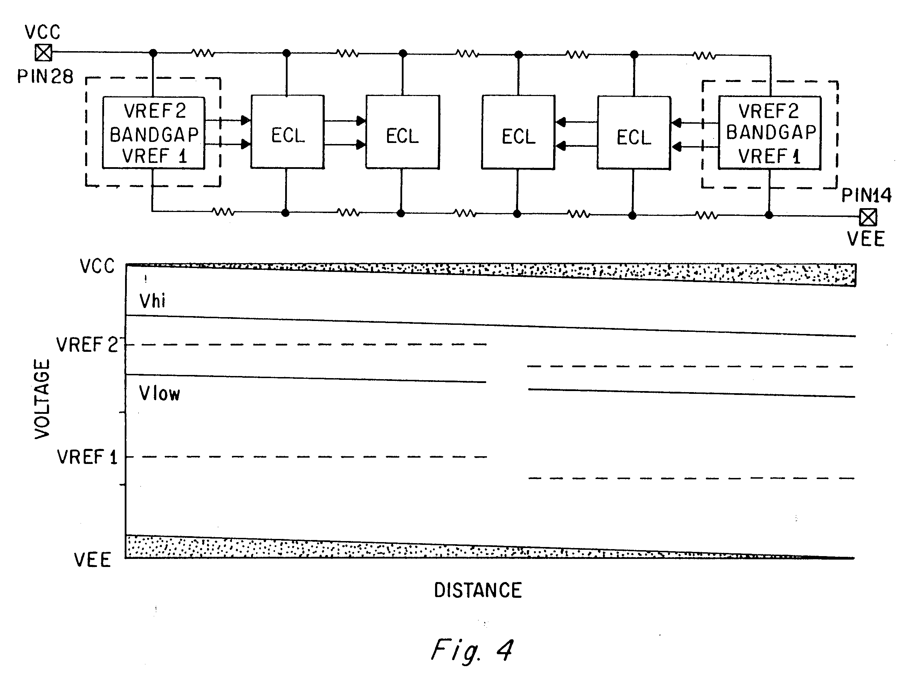

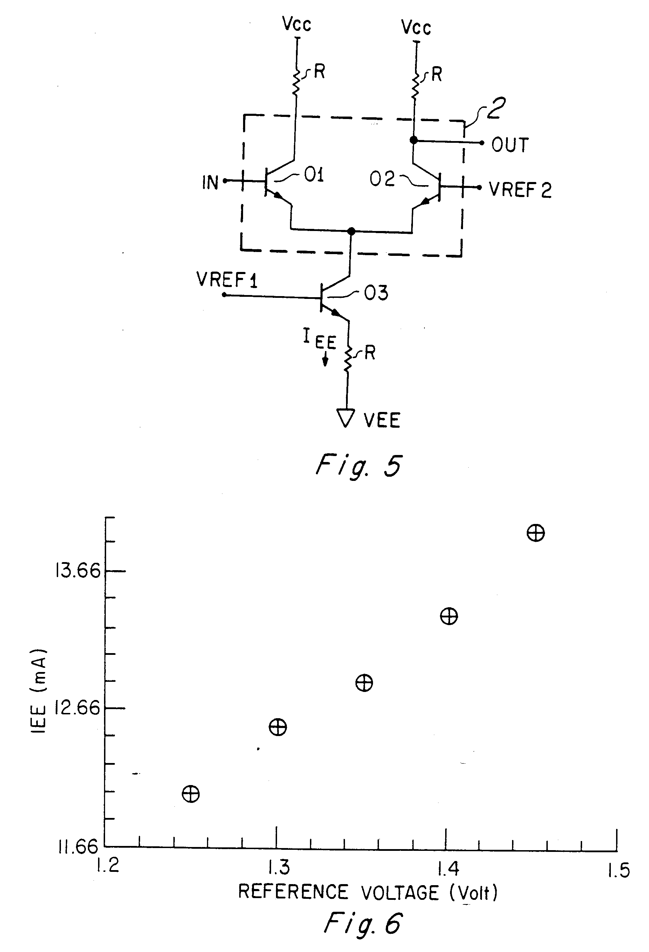

Figure 4 illustrates multiple (two) band-gap reference circuits in a configuration similar to that shown in figures 2 and 3. Figure 4 additionally illustrates a corresponding graph of selected voltages vs. distance. Two band-gap circuits are placed at each end of the package. Large layout areas are required for this scheme. Additionally, the critical location of these reference circuits reduce the effectiveness of the scheme. The ECL circuits farthest from the reference circuits still suffer signal degredations and still depend on how much power line voltages have dropped at their location. A similar problem arises in other circuits involving current mode logic, CML, gates. Figure 5 illustrates a standard CML gate comprising differential Figure 2 comprising transistors O1 and O2 connected to transistor O3. It can be easily seen that variations in either the value of VREF1 or VEE will cause variations in the signal swing as well as the current drawn by this gate. Furthermore, variations in VREF2 or VCC can adversely impact the noise margin required to make this circuit element function reliably. The effect of the reference voltage on current of a BiCMOS/ECL circuit block is shown in figure 6, which illustrates the variation in current IEE with respect to reference voltage variation.

The before mentioned document EP-A-0 282 725 describes a reference network in which a differential voltage is generated which is amplified and shifted to provide a single ended voltage; then unwanted components from the single ended voltage are removed. While the unwanted components are removed using two current mirrors, this is done at a single location for a particular reference voltage. A reference current is not routed to a plurality of voltage generation circuits.

### OBJECTS OF THE INVENTION

It is an object of the invention to provide a new and improved reference network.

It is another object of the invention to provide a BiCMOS reference network.

These and other objects of the invention, together with the features and advantages thereof, will become apparent from the following detailed specification when read together with the accompanying drawings in which applicable reference numerals have been carried forward.

### SUMMARY OF THE INVENTION

The foregoing objects of the invention are accomplished by a reference network of the type described above and provided with the features of the characterizing part of claim 1. In particular this network establishes reference voltages which are defined with respect to local power supply levels. The local supply levels are established through the use of a network of reference current sources. The reference current sources can be routed across the chip without having to give special consideration to power supply fluctuations. The current sources serve as inputs to analog drivers which generate the reference voltages with the respect to the local power supply levels. The semiconductor chip on which the invention is embodied uses a global band-gap reference circuit that operates in conjunction with current source feed back implemented with a PMOS current mirror. BiCMOS Op Amps are used as the analog drivers. The analog drivers convert band-gap reference outputs to the required levels and provide low impedance sources to ECL circuits for the chip. By converting the global band-gap voltage (from the global band-gap reference circuit) to current references and regenerating a voltage reference at a local ECL circuit block, the effects of voltage drop differences between the power supply lines of the global band-gap circuit and the local ECL blocks are substantially eliminated.

### ADVANTAGES OF THE INVENTION

The invention has advantages which include the following:
1. A concise ECL signal voltage swing within an ECL circuit block for maximum speed.
2. Tracked reference for single ended ECL signals to achieve maximum signal margin.
3. Precise reference levels for off-chip interfaces to provide high performance I/O's.
4. The effect of the power supply lines voltage drop are minimized and contained inside circuit blocks.
5. Improved chip operation margin is achieved by preventing the feed back noise of switching gates from propagating back to the band-gap reference circuit.
6. Low impedance voltage reference sources provide high current handling capability which in turn serve to improve the bipolar transistor process margin.

### BRIEF DESCRIPTION OF THE DRAWINGS

Figure 1 illustrates a standard ECL gate.

Figure 2 illustrates the physical layout of VCC and VEE power supply pads on a semiconductor chip and an associated graph.

Figure 3 illustrates an example of a SRAM which is designed to fit in a standard JDEC package.

Figure 4 illustrates multiple band-gap reference circuits in a configuration similar to that shown in figures 2 and 3.

Figure 5 illustrates a standard CML gate.

Figure 6 illustrates the variation in current IEE with respect to reference voltage variation.

Figure 7 illustrates a preferred embodiment of the invention together with a graph of selected voltages vs. chip distance.

Figure 8 illustrates an embodiment of the invention similar to that shown in figure 7. The VCC power line, however, has been minimized through allocation of more area for it in a circuit layout.

Figure 9 illustrates a standard band-gap reference circuit.

Figure 10 illustrates the BiCMOS band-gap circuit used in the invention.

Figure 11 shows the output of the invention's band-gap circuit versus a VCC voltage from 3 to 7 volts.

Figure 12 illustrates the reference current to voltage conversion circuit of the invention.

Figure 13 illustrates an Op Amp driver circuit.

Figure 14 illustrates a block diagram of the reference network.

### DETAILED DESCRIPTION OF THE INVENTION

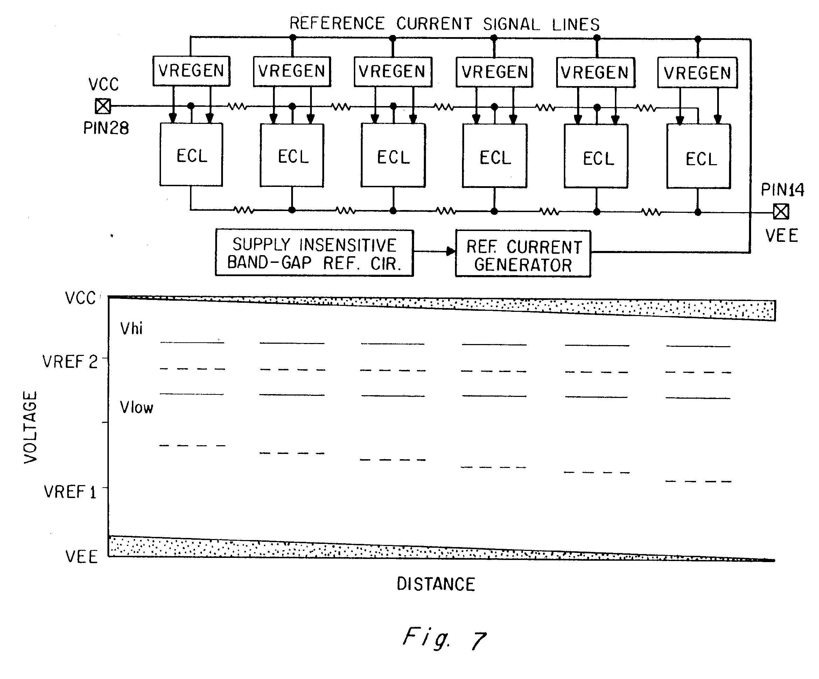

Figure 7 illustrated a preferred embodiment of the invention together with a graph of selected voltages vs. chip distance. Each ECL circuit block has its own reference circuit VREGEN. The ECL circuits receive not the voltages, but the current references from a reference current generator. A reference current generator converts the voltage from a band-gap reference circuit to currents before sending the signal to remote locations such as ECL gates distributed on a chip. At these locations, the reference current will be converted to voltage to provide a correct reference voltage for a local circuit such as a local ECL gate. The invention thus substantially eliminates the previously discussed problem of voltage drop in power supply lines leading to each ECL block. As shown in the graph, VREF1 and VREF2 are correctly referenced to the local power supply levels. Maximum signal margin is restored because the I/O signals inside each ECL block are now at correct levels. Notice that the signals are only offset from block to block.

Several circuit techniques can now be used to resolve problems of global signal communication between ECL circuit blocks. These techniques include the following: differential signal usage; single ended signals with trip point reference from the sender; level shifter circuits; and minimization of VCC power line voltage drops. To keep the VCC drop at a minimum, more area on the VCC line in a layout can be used. A wider VCC power line reduces resistance. Prior to the invention, both VCC and VEE lines had to be widened in order to minimize voltage drops. Depending upon the individual circuit requirements, one of these techniques, or all, can be used. The differential signals for the communication between ECL blocks provide the best signal margin but require the most layout area and also restrict the logic operation which can be performed with the available signals. Single ended signals can be used. However, the trip point reference level should be sent to the receiving circuit from the sender to improve the signal margin. Level shifter circuits at both sender or receiver will provide an effective communication but it will add some complicated circuitry. However, the simplest technique improves the ground line. Reducing the voltage drops of the VCC line (widening the VCC power line) in the ECL circuit will effectively improve the signal margin by the same amount.

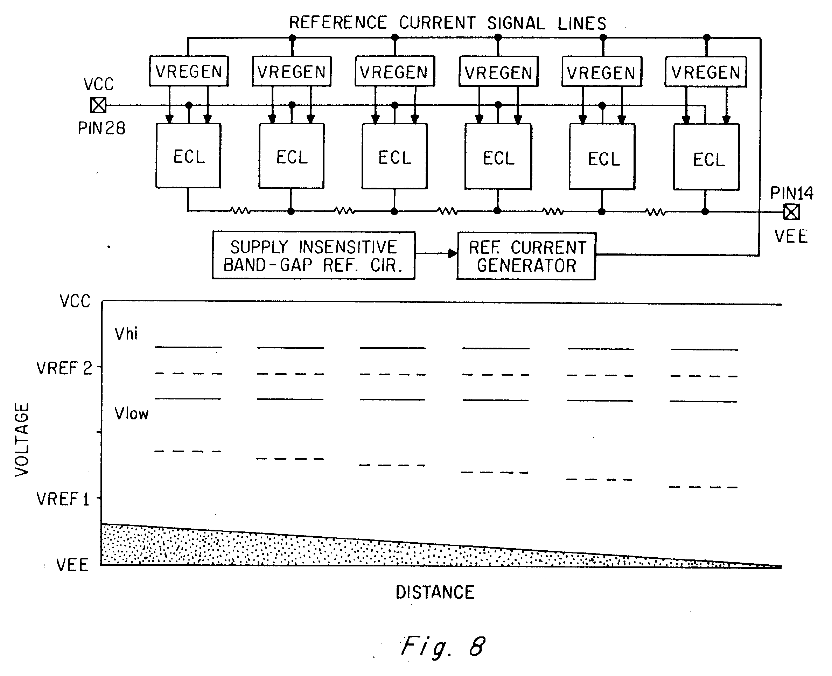

Figure 8 illustrates an embodiment of the invention similar to that shown in Figure 7. However, the VCC power line voltage drop has been minimized through allocation of more area for it in a circuit layout. As shown in the graph, the invention allows the circuit to tolerate the voltage drops on the VEE line much more than the standard reference techniques. If the VCC power line voltage is as shown, then all ECL I/O (input/output) signals from all blocks will be aligned. The invention makes the physical location of the band-gap and the current generator with respect to power pads and circuit blocks noncritical.

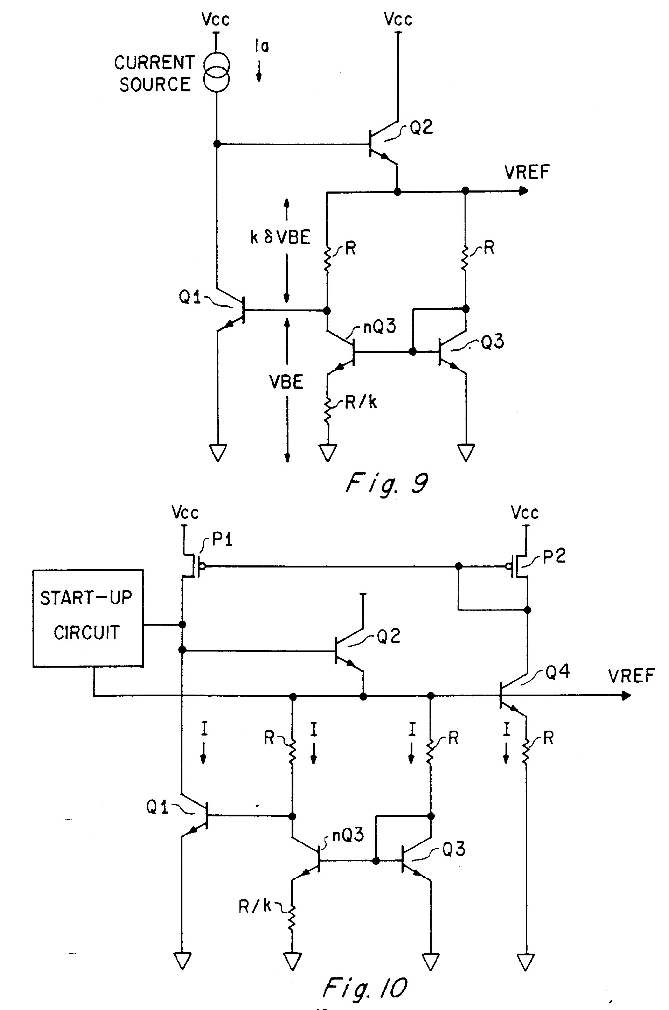

A key component of the network of the invention is a BiCMOS band-gap circuit which is insensitive to the power supply variations. This band-gap circuit was disclosed in Serial Number 07/161,694, filed February 29, 1988. In order to fully explain this circuit, reference shall be made to figure 9, which illustrates a standard band-gap reference circuit. A current source is connected to the base of N-type bipolar transistor Q2 and the collector of N-type bipolar transistor Q1. The base of Q1 is connected to the collector of n-type transistor nQ3 and the bases of transistor nQ3 and transistor Q3 are connected together. Resistors are illustrated with their relative values displayed alongside. Voltages are displayed between arrowheads. The output of the circuit results in a reference voltage VREF. The reference output VREF is equal to the sum of VBE and k*delta VBE (k being the denominator of the resistor connected to the collector of transistor nQ3). Transistor Q1 is used as a negative feedback amplifier to keep the VREF at nearly equal to the band-gap voltage of silicon (about 1.25 volt) for maximum temperature stability. The variation of the load current Ia (from the current source) of this circuit has a direct effect on the VREF output. One of the main causes of the Ia current variation is the power supply fluctuation. The band-gap circuit of the invention keeps the current Ia as stable as possible. There are many existing circuit techniques to generate a stable current source for this purpose, but they are often unreliable, complicated and required a large layout area. For example, one of the most common design techniques is using another band-gap to generate the Ia current.

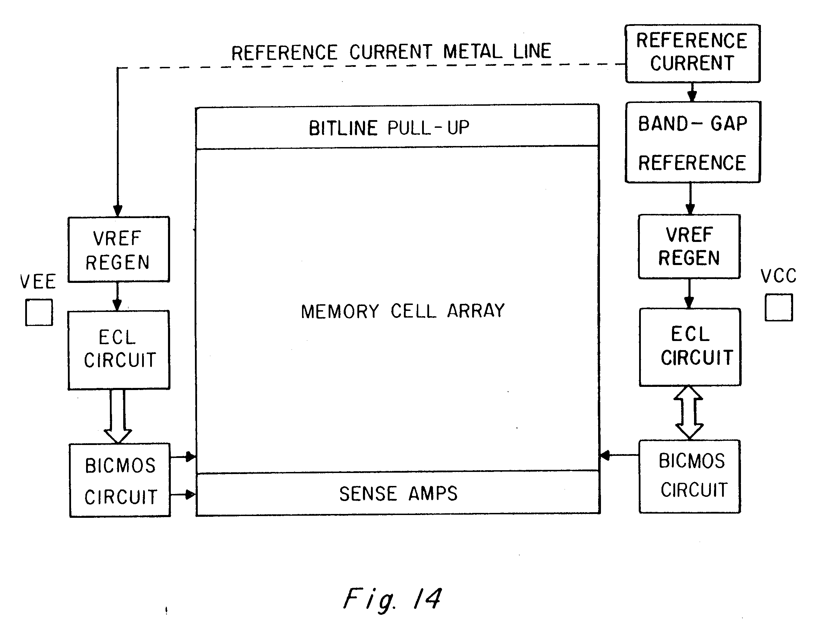

Figure 10 illustrates the BiCMOS band-gap circuit used in the invention. Unlike standard band-gap circuits, this circuit is simple and does not require a second band-gap circuit to generate the Ia current. This circuit uses its own band-gap output to generate a load current. This is accomplished by using the P-channel MOS transistors, P1 and P2, to mirror the current I which is generated by the output voltage VREF, from transistor Q4 through resistor R, and to the load of a feed back amplifier, transistor Q1. A stable voltage output VREF will provide a steady load current and vice versa by the self-feed-back. As shown, a start-up circuit is required to keep the circuit out of zero current mode (which produces zero feed back) due to the self-feed-back. Once the reference output is at a correct level, the start-up circuit is no longer needed and should be electrically disconnected to avoid possible ill effects. Notice that the currents flowing in the branches are kept equal for maximum tracking ability.

Figure 11 shows the output of the invention's band-gap circuit versus a VCC voltage from 3 to 7 volts. Fourteen milivolts of output variation was seen across the entire range (.35%), but the circuit operates much better in a VCC range from 4 to 7 volts. The output only varied 5 milivolts in this range (.16%).

Figure 12 illustrates the reference current to voltage conversion circuit of the invention. This circuit is used at each local location of an ECL circuit block. The global band-gap voltage VREF is converted to a reference current IREF and then routed to a remote ECL circuit block. At the ECL block, the IREF current is mirrored by P-channel transistors 13 and 15 and passed through bipolar transistor Q20 and resistor R to regenerate the VREF level that corresponds to the local VEE voltage level. The output from this circuit can be directly connected to ECL circuits (as shown) or can be connected to an operational amplifier (Op Amp) to provide greater current handling capability or more flexibility to regenerate different voltage reference levels. The VREF signal is taken from the emitter of transistor Q10 which is connected to P-channel transistor 15 and bipolar transistor Q20.

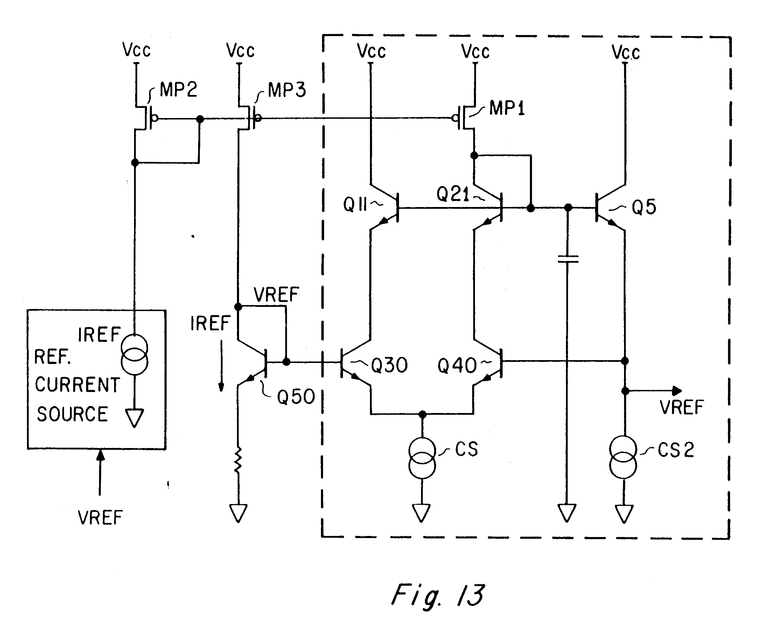

Figure 13 illustrates the Op Amp driver circuit discussed above. The Op Amp driver is shown inside the dashed box. The Op Amp is connected in a unity gain configuration to produce at its output the same voltage level connected to its input. It uses a P-channel current source NP1 for the load to improve the gain of the differential stage comprising bipolar transistors Q30, Q40 and current source CS. The cascode transistors Q11 and Q21 are used to minimize the input offset which might be caused by the difference of the VCE voltage between transistors Q30 and Q40. The output from the Op Amp driver circuit is taken from the emitter of transistor Q5. Other circuitry for implementing the connection of the Op Amp to the rest of the scheme comprises gate connected P-channel transistors MP2 and MP3. Diode configured transistor Q50 is connected to P-channel transistor MP3 and generates a reference current IREF.

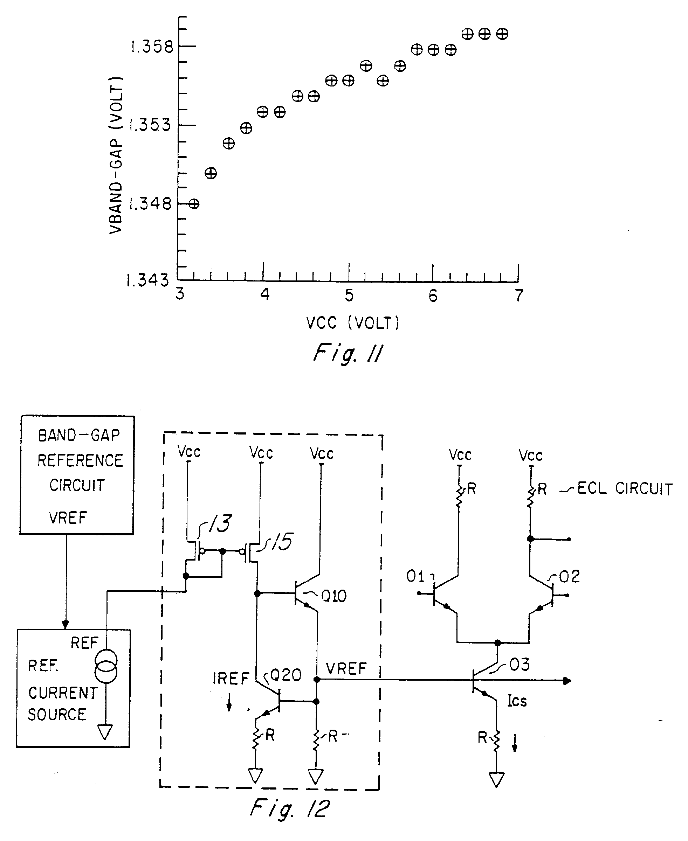

An experimental prototype of the invention has been fabricated with 0.8u BiCMOS double metal process. The operating power supply is from 0 to 7 volts. Most of the layout area of the band-gap and the Op Amp are consumed by compensation capacitors used for operation stability. The output band-gap voltage was measured at 1.356 volt with the temperature coefficient of 200 ppm per degree C. This is a bit high because the nonoptimum resistor k factor in the band-gap. The open loop gain of the Op Amp was only 45 db but this is adequate for its purpose in the network. 1 mv of input offset was measured and the power supply reject ratio of the band-gap circuit was 47db while the rejection ratio for the Op Amp was 67db. The network was implemented in a 1meg BiCMOS SRAM. The block diagram of the network is shown in figure 14. Power supply pads are at the opposite side of the chip. The global band-gap is placed near VCC power pad. Reference current is routed to the other side of the network and regenerated at local ECL circuit locations. BiCMOS circuits are used for global communications in this SRAM. The characteristics of the foregoing network include minimized power supply drop effects, maximized ECL signal margin, and improved ECL circuit performance of a VLSI BiCMOS ECL chip.

Although the invention has been described in detail herein with reference to its preferred embodiment and certain described alternatives, it is to be understood that this description is by way of example only, and is not to be construed in a limiting sense. It is to be further understood that numerous changes in the details of the embodiments of the invention, and additional embodiments of the invention, will be apparent to and may be made by persons of ordinary skill in the art having reference to this description. For instance, other types of logic circuits may be substituted for the emitter coupled logic gates previously described. These include TTL, DTL, RTL, and CML circuits. Additionally, analog circuits may be substituted for the logic circuits. Furthermore, any circuit requiring a reference voltage may be substituted for the ECL circuit previously discussed. Although field-effect and bipolar transistors have been shown in specific instances in the drawings, bipolar transistor may substituted for field-effect transistors and vice-versa. Furthermore, P-type transistors may be substituted for n-type transistors and vice-versa. Likewise, N-channel transistors may be substituted for P-channel transistors and vice-versa.

## Claims

1. An on-chip reference network comprising:
a voltage reference circuit being operative to produce a reference voltage (VREF);
a reference current generator operatively associated with said voltage reference circuit so as to produce a reference current (IREF) derived from said reference voltage (VREF); and
a plurality of sub-circuits (ECL) at different locations on the chip each requiring a certain reference voltage (VREF) for proper operation; characterized by
a plurality of voltage generation circuits (VREGEN) each located at said different locations and connected to said reference current generator and operative to provide said certain reference voltage (VREF) based on said reference current (IREF) to one of said sub-circuits (ECL).

2. A reference network as recited in claim 1 further comprising at least one power supply (VCC) connected thereto.

3. A reference network as recited in claim 1 further comprising connections for the supply of power.

4. A reference network as recited in claim 1 wherein said voltage reference circuit is of the band-gap variety comprising:
a transistor (Q4) including at least a first and second terminal wherein the bias of said first terminal controls a reference current (I) through said second terminal;
a current mirror (P1, P2) connected to said second terminal of said transistor (Q4) for mirroring through itself, the reference current (I) through said second terminal; and
a band-gap sub-circuit, connected to said current mirror (P1, P2), for providing a bias, determined by the mirror current (P1, P2) to said first terminal.

5. A reference network as recited in claim 4 wherein said current mirror (P1, P2) comprises a pair of gate connected transistors.

6. A reference network as recited in claim 5, wherein one of said prior of gate connected transistors (P2) is connected in a diode configuration.

7. A reference network as recited in claim 1, wherein each of said plurality of voltage generation circuits (VREGEN) comprises:
a current mirror (13, 15) coupled to a current to a voltage conversion circuit.

8. A reference network as recited in claim 7, wherein said voltage conversion circuit comprises a first transistor (Q10) connected to a second transistor (Q20) supplying a reference voltage output (VREF).

9. A reference network as recited in claim 7, wherein said current mirror (13, 15) comprises two gate connected field effect transistors (13, 15).

10. A reference network as recited in claim 8, wherein said first and second transistors (13, 15) are bipolar transistors.

11. A reference network as recited in claim 7 wherein said current to voltage conversion circuit comprises an operational amplifier.

12. A reference network as recited in claim 11, wherein said operational amplifier is a BiCMOS operational amplifier.

13. A reference network as recited in claim 11, wherein said operational amplifier comprises a differential amplifier and a field effect current source (CS) connected to said differential amplifier; said current source (CS) in operation serving as a load for said differential amplifier.

14. A reference network as recited in claim 13 wherein said field-effect current source (CS) is operative to mirror said reference current (IREF) from said reference current generator.

15. A method of generating reference voltages (VREF) for circuits (ECL) at a plurality of locations, said circuits requiring a certain reference voltage (VREF) for proper operation, comprising the steps of:
producing a global reference voltage (VREF); and
generating a reference current (IREF) derived from said global reference voltage (VREF);
characterised by the steps of:
converting said reference current (IREF) to said certain reference voltage (VREF) at said plurality of circuit locations (ECL);
providing said certain reference voltage, derived from said reference current (IREF), to said circuits (ECL).

## Patentansprüche

1. Chipinterne Referenzschaltung, enthaltend:
eine Referenzspannungsschaltung, die eine Referenzspannung (VREF) erzeugt;
einen Referenzstromgenerator, der der Referenzspannungsquelle wirkungsmäßig so zugeordnet ist, daß er einen von der Referenzspannung (VREF) abgeleiteten Referenzstrom (IREF) erzeugt; und
mehrere Teilschaltungen (ECL) an verschiedenen Stellen auf dem Chip, die jeweils eine gewisse Referenzspannung (VREF) für das richtige Arbeiten benötigen; gekennzeichnet durch
mehrere Spannungserzeugungsschaltungen (VREGEN), die jeweils an den verschiedenen Stellen angeordnet sind und mit dem Referenzstromgenerator verbunden sind und die gewisse Referenzspannung (VREF) auf der Basis des Referenzstroms (IREF) an eine der Teilschaltungen (ECL) liefern.

2. Referenzschaltung nach Anspruch 1, ferner enthaltend wenigstens eine an sie angeschlossene Stromversorgung (VCC).

3. Referenzschaltung nach Anspruch 1, ferner enthaltend Verbindungen für die Zufuhr von Energie.

4. Referenzschaltung nach Anspruch 1, bei welcher die Referenzspannungsschaltung vom Band-Gap-Typ ist und enthält:
einen Transistor (Q4) mit wenigstens einem ersten und einem zweiten Anschluß, wobei die Vorspannung des ersten Anschlusses einen durch den zweiten Anschluß fließenden Referenzstrom (I) steuert;
einen Stromspiegel (P1, P2), der mit dem zweiten Anschluß des Transistors (Q4) verbunden ist, um durch sich den durch den zweiten Anschluß fließenden Referenzstrom (I) zu spiegeln; und
eine Band-Gap-Teilschaltung, die mit dem Stromspiegel (P1, P2) verbunden ist, um eine durch den Stromspiegel (P1, P2) bestimmte Vorspannung an den ersten Anschluß anzulegen.

5. Referenzschaltung nach Anspruch 4, bei welchem der Stromspiegel (P1, P2) zwei an ihrem Gate-Anschluß verbundene Transistoren enthält.

6. Referenzschaltung nach Anspruch 5, bei welchem einer der zwei an den Gate-Anschlüssen verbundenen Transistoren (P2) als Diode geschaltet ist.

7. Referenzschaltung nach Anspruch 1, bei welcher die mehreren Spannungsgeneratorschaltungen (VREGEN) enthalten:
einen Stromspiegel (13, 15), der an eine Strom/Spannungs-Umsetzungsschaltung angeschlossen ist.

8. Referenzschaltung nach Anspruch 7, bei welcher die Spannungsumsetzungsschaltung einen ersten Transistor (Q10) enthält, der an einen zweiten Transistor (Q20) angeschlossen ist, der eine Referenzausgangsspannung (VREF) liefert.

9. Referenzschaltung nach Anspruch 7, bei welcher der Stromspiegel (13, 15) zwei mit ihren Gate-Anschlüssen verbundene Feldeffekttransistoren (13, 15) enthält.

10. Referenzschaltung nach Anspruch 8, bei welcher der erste und der zweite Transistor (13, 15) bipolare Transistoren sind.

11. Referenzschaltung nach Anspruch 7, bei welcher die Strom/Spannungs-Umsetzungsschaltung einen Operationsverstärker enthält.

12. Referenzschaltung nach Anspruch 11, bei welcher der Operationsverstärker ein BiCMOS-Operationsverstärker ist.

13. Referenzschaltung nach Anspruch 11, bei welcher der Operationsverstärker einen Differenzverstärker und eine an den Differenzverstärker angeschlossene Feldeffekt-Stromquelle (CS) enthält, wobei die Stromquelle (CS) im Betrieb als Last für den Differenzverstärker dient.

14. Referenzschaltung nach Anspruch 13, bei welcher die Feldeffekt-Stromquelle (CS) das Spiegeln des Referenzstroms (IREF) aus dem Referenzstromgenerator bewirkt.

15. Verfahren zum Erzeugen von Referenzspannungen (VREF) für Schaltungen (ECL) an verschiedenen Stellen, wobei die Schaltungen für den richtigen Betrieb eine gewisse Referenzspannung (VREF) benötigen, enthaltend die Schritte:
Erzeugen einer globalen Referenzspannung (VREF); und
Erzeugen eines von der globalen Referenzspannung (VREF) abgeleiteten Referenzstroms (IREF);
gekennzeichnet durch die Schritte:
Umsetzen des Referenzstroms (IREF) auf die gewisse Referenzspannung (VREF) an den mehreren Schaltungsstellen (ECL);
Zuführen der von dem Referenzstrom (IREF) abgeleiteten gewissen Referenzspannung zu den Schaltungen (ECL).

## Revendications

1. Réseau de référence intégré sur une puce comprenant :
un circuit de référence de tension apte à produire une tension de référence (VREF) ;
un générateur de courant de référence fonctionnellement associé audit circuit de référence de tension de façon à produire un courant de référence (IREF) dérivé de ladite référence de tension (VREF) ; et
une pluralité de sous-circuits (ECL) à différents endroits de la puce, chacun nécessitant une certaine référence de tension (VREF) pour un fonctionnement adéquat ; caractérisé par
une pluralité de circuits de génération de tension (VREGEN) chacun disposé auxdits différentes endroits et connecté audit générateur de courant de référence et apte à fournir ladite certaine référence de tension (VREF) basée sur ladite référence de courant (IREF), à l'un desdits sous-circuits (ECL).

2. Réseau de référence selon la revendication 1, comprenant en outre au moins une alimentation de puissance (VCC) y connectée.

3. Réseau de référence selon la revendication 1, comprenant en outre des connexions pour l'alimentation de puissance.

4. Réseau de référence selon la revendication 1, dans lequel ledit circuit de référence de tension est du type à saut de bande comprenant :
un transistor (Q4) comprenant au moins une première et une seconde bornes, dans lequel la polarisation de ladite première borne commande un courant de référence (I) à travers ladite seconde borne ;
un miroir de courant (P1, P2) connecté à ladite seconde borne dudit transistor (Q4) pour réfléchir à travers lui-même, la référence de courant (I) à travers ladite seconde borne ; et
un sous-circuit à saut de bande connecté audit miroir de courant (P1, P2), pour fournir une polarisation, déterminée par le miroir de courant (P1, P2) à ladite première borne.

5. Réseau de référence selon la revendication 4, dans lequel ledit miroir de courant (P1, P2) comporte une paire de transistors connectés par la grille.

6. Réseau de référence selon la revendication 5, dans lequel l'un des transistors de ladite paire connectés par la grille (P2) est connecté selon une configuration de diode.

7. Réseau de référence selon la revendication 1, dans lequel chacun de la pluralité de circuits de génération de tension (VREGEN) comporte :
un miroir de courant (13, 15) couplé à un circuit de conversion de courant en tension.

8. Réseau de référence selon la revendication 7, dans lequel ledit circuit de conversion de tension comporte un premier transistor (Q10) connecté un second transistor (Q20) fournissant une sortie de référence de tension (VREF).

9. Réseau de référence selon la revendication 7, dans lequel ledit miroir de courant (13, 15) comporte deux transistors à effet de champ (13, 15) connectés par la grille.

10. Réseau de référence selon la revendication 8, dans lequel lesdits premier et second transistors (13, 15) sont des transistors bipolaires.

11. Réseau de référence selon la revendication 7, dans lequel ledit circuit de conversion de courant en tension comporte un amplificateur opérationnel.

12. Réseau de référence selon la revendication 11, dans lequel ledit amplificateur opérationnel est un amplificateur opérationnel BiCMOS.

13. Réseau de référence selon la revendication 11, dans lequel ledit amplificateur opérationnel comporte un amplificateur différentiel et une source de courant à effet de champ (CS) connectée audit amplificateur opérationnel ; ladite source de courant (CS) servant en fonctionnement, de charge pour ledit amplificateur opérationnel.

14. Réseau de référence selon la revendication 13, dans lequel ladite source de courant à effet de champ (CS) fonctionne pour réfléchir ladite référence de courant (IREF) dudit générateur de courant de référence.

15. Procédé pour générer des tensions de référence (VREF) pour des circuits (ECL) à une pluralité de points, ledit circuit nécessitant une certaine référence de tension (VREF) pour un fonctionnement correct, comprenant les étapes consistant à :
produire une référence de tension globale (VREF) ; et
générer un courant de référence (IREF) dérivé de ladite référence globale de tension (VREF) ;
caractérisé par les étapes consistant à :
convertir ladite référence de courant (IREF) en ladite certaine référence de tension (VREF) à ladite pluralité de points du circuit (ECL) ;
fournir ladite certaine référence de tension, dérivée de ladite référence de courant (IREF), auxdits circuits (ECL).
